(19) Europäisches Patentamt
European Patent Office
Office européen des brevets

(11) EP 1 000 368 B1

(12) **EUROPÄISCHE PATENTSCHRIFT**

(45) Veröffentlichungstag und Bekanntmachung des Hinweises auf die Patenterteilung:
**27.08.2003   Patentblatt 2003/35**

(51) Int Cl.⁷: **G01S 13/18**, H03K 7/08

(21) Anmeldenummer: **99936307.0**

(22) Anmeldetag: **25.05.1999**

(86) Internationale Anmeldenummer:
**PCT/DE99/01532**

(87) Internationale Veröffentlichungsnummer:
**WO 99/063362 (09.12.1999 Gazette 1999/49)**

(54) **ABTASTER-STEUEREINRICHTUNG**

SAMPLER CONTROL DEVICE

DISPOSITIF DE COMMANDE D'ECHANTILLONNEUR

(84) Benannte Vertragsstaaten:
**DE FR GB IT**

(30) Priorität: **29.05.1998   DE 19824037**

(43) Veröffentlichungstag der Anmeldung:
**17.05.2000   Patentblatt 2000/20**

(73) Patentinhaber: **ROBERT BOSCH GMBH**
**70442 Stuttgart (DE)**

(72) Erfinder:
• **PFENDLER, Thomas**
**D-70839 Gerlingen (DE)**
• **STEINLECHNER, Siegbert**
**D-71229 Leonberg (DE)**

(56) Entgegenhaltungen:
**US-A- 5 543 799          US-A- 5 563 605**
**US-A- 5 757 320**

**Beschreibung**

Stand der Technik

Die Erfindung bezieht sich auf eine Abtaster-Steuereinrichtung für die Abtastung eines durch zurückkommende Sendeimpulse gebildeten Echosignals mit einem Taktgenerator, der einen Pulsformer für die Sendeimpulse und einen weiteren Pulsformer für Abtastimpulse periodisch anstößt, und mit einem Einstellglied zum Ändern einer Verzögerungszeit $\Delta\tau$ der Abtastimpulse, so daß das Echo-signal aus den zurückkommenden Sendeimpulsen nach und nach rekonstruierbar ist.

Eine derartige Abtaster-Steuereinrichtung findet auf vielen technischen Gebieten Anwendung, beispielsweise um in einem inhomogenen Medium oder an Grenzflächen reflektierte Echosignale von Sendeimpulsen wieder zu empfangen und auszuwerten. Über eine Laufzeitmessung kann z.B. Information über die Länge der Strecke, die das Signal durchlaufen hat, gewonnen werden. Anwendungs-beispiele sind die Abstandsmessung mit Schall-, Radar- oder Lichtwellen. Die Echsosignalform kann weiterhin Aufschluß geben über die Struktur des durchlaufenen Mediums, wie z.B. bei der Bestimmung der Nebeldichte in der Atmosphähre mit Lichtwellen oder bei seismischen Messungen des Schichtverlaufs in der Erde oder bei Messungen von Materialschichten in Rohren und Wänden mittels Radar, um nur einige Beispiele zu nennen.

in den meisten Fällen ist eine Auswertung in Echtzeit, d.h. in der Geschwindigkeit, mit der die Echosignale eintreffen, wegen einer zu geringen Geschwindigkeit der Auswerteschaltung nicht möglich. Dies trifft insbesondere bei der Auswertung von Signalen zu, die sich mit Lichtgeschwindigkeit ausbreiten. Deshalb werden hierbei Abtasteinrichtungen verwendet, bei denen das Echosig-nal schrittweise abgetastet wird, wodurch die für die Auswertung erwünschte Zeitdehnung auftritt. Bei einem derartigen Abtastsystem stößt ein Taktgenerator periodisch einen Impulsformer an, der Sendeimpulse an das zu untersuchende System abgibt. Das zurückkommende Echosignal wird in einem Abtaster nach einer variablen Zeit $\Delta\tau$ abgetastet. Der zu einem Zeit-punkt nach der Verzögerung $\Delta_T$ gehörende Abtastwert gelangt zur weiteren Signalverarbeitung. Durch Variation der Verzögerung $\Delta\tau$ kann das gesamte Echosignal nach und nach rekonstruiert werden.

Die bekannten Verfahren zur Erzeugung von um eine Verzögerung $\Delta\tau$ verzö-gerten Abtastimpulsen sind entweder ungenau oder sehr aufwendig, insbesondere für sehr kleine Schrittweiten und/oder große Variationsbereiche.

In der US-PS 5 543 799 ist ein Nahbereichsradar beschrieben, bei dem eine variable, spannungsgesteuerte Verzögerung der Sendeimpulse stattfindet. Die Verzögerung hängt unter Umständen nicht linear von einer Steuerspannung ab und ist daher ungenau.

Die Firma Analog Devices bietet eine digitale Schaltung mit steuerbarer Zeitverzögerung (AD9501, AD9505) an, wobei die Linearität über die Erzeugung einer hochgenauen Rahmenfunktion eingehalten wird.

Der Erfindung liegt die Aufgabe zugrunde, eine Abtaster-Steuereinrichtung der eingangs genannten Art derart weiterzubilden, daß die Sendeimpulse und die verzögerten Abtastimpulse sehr genau erzeugt werden und das Echosignal sehr genau reproduzierbar ist.

Diese Aufgabe wird mit den Merkmalen des Anspruchs 1 gelöst. Hiernach ist vorgesehen, daß der Pulsformer für die Sendeimpulse Glied einer ersten Regelschleife mit einer Summationsstelle und einem Regler und der weitere Pulsformer Glied einer zweiten Regelschleife mit einer weiteren Summationsstelle und einem weiteren Regler ist und daß der Summationsstelle und der weiteren Summationsstelle ein gleicher Sollwert und der weiteren Summationsstelle zusätzlich ein weiterer Sollwert, der zum Ändern der Verzögerungszeit variiert wird, zugeführt werden. Durch die Regelung der Abgabe der Sendeimpulse und der Abtastimpulse in dieser Weise werden die Sendeimpulse und Abtastimpulse in genau vorgegebener Weise erzeugt und auch der zeitliche Bezug aufeinander stabil eingehalten.

Eine stabile Regelung bei einfachem Aufbau der Steuereinrichtung wird dadurch erzielt, daß der Pulsformer und der weitere Pulsformer jeweils mindestens ein Schaltglied aufweisen, das bei einer bestimmten Schwellenspannung umschaltet und daß mittels des Reglers und des weiteren Reglers eine an das Schaltglied angelegte Steuer-Gleichspannung geregelt wird.

Eine Regelabweichung wird beispielsweise dadurch sicher erfaßt, daß der der Summationsstelle und der weiteren Summationsstelle zugeführte Sollwert sowie der weitere Sollwert Gleichspannungen sind.

Ist vorgesehen, daß der weitere Sollwert eine mittels eines Zählers und eines diesem nachgeschalteten D/A-Wandlers gebildete Gleichspannung ist und daß der Zähler mittels des Taktgenerators getaktet ist, wird eine sehr fein quan-tisierbare Änderung der Verzögerung erzielt, wobei Werte von unter 50 ps re-produzierbar möglich sind.

Eine Ausführungsform, die sich auch für schnell ändernde Steuerspannungen eignet und mit der ein großer nutzbarer Frequenzbereich für das Steuersignal erzielt wird, wobei der Regler nur noch Fehler in der gewählten Gewichtung und Effekte von Nichtlinearitäten ausgleichen muß, besteht darin, daß in der zweiten Regelschleife zwischen dem weiteren Regler und dem weiteren Laufzeitglied ein Summationsglied vorgesehen ist, dem der weitere Sollwert zugeführt wird.

Ein einfacher Aufbau zur Erzeugung und Regelung der Sendeimpulse und Abtastimpulse wird dadurch erzielt, daß das Schaltglied ein AND-Gatter aufweist, dessen einem Eingang das Taktsignal des Taktgenerators zugeführt ist und dessen anderer Eingang mit einem RC-, RL- oder LC-Glied beschaltet und mit einem Eingangssignal mit der überlagerten Steuer-Gleichspannung beaufschlagt ist. Durch Überlagerung der Steuer-Gleichspannung läßt sich die Laufzeit der Anordnung verändern, da das Gatter immer im gleichen Schaltpunkt schaltet und sich die Verzögerung durch die Steuerspannung definiert verschiebt. Dabei ist die Maßnahme zweckmäßig, daß dem anderen Eingang als Eingangssignal das invertierte Taktsignal mit der überlagerten Steuer-Gleichspannung zugeführt wird.

Eine weitere vorteilhafte Ausgestaltung der Steuereinrichtung für eine stabile, hochgenaue Regelung der Sendeimpulse und Abtastimpulse besteht darin, daß das Schaltglied ein NAND-Gatter und ein Flipflop aufweist, dessen Takt-Eingang das Taktsignal des Taktgenerators zugeführt wird und dessen einer Ausgang über ein Zeitglied mit einem Eingang des NAND-Gatters verbunden ist und zum Regler bzw. weiterer Regler geführt, daß der andere Eingang des NAND-Gatters über ein weiteres Zeitglied einerseits mit dem Taktsignal und andererseits mit der diesem überlagerten Steuer-Gleichspannung beaufschlagt wird und daß der Ausgang des NAND-Gatters mit einem Rücksetzeingang des Flipflops verbunden ist und abfallende Flanken des Ausgangssignals des NAND-Gatters direkt zum Triggern der Sendeimpulse bzw. der Abtastimpulse dienen. Bei dieser Ausfüh-rungsform erübrigt sich eine weitere Schaltung, die aus der abfallenden Flanke des zum Regler geführten Signals die Sendeimpulse bzw. Abtastimpulse erzeugt. Die Lage der abfallenden Flanke, die den Sendezeitpunkt bzw. Abtastzeitpunkt bestimmt, wird bei dieser Ausführung mitgeregelt.

Die Erfindung wird nachfolgend anhand von Ausführungsbeispielen unter Bezugnahme auf die Zeichnungen näher erläutert. Es zeigen:

Fig. 1    ein Blockschaltbild für ein erstes Ausführungsbeispiel der Abtaster-Steuereinrichtung,

Fig. 2    ein weiteres Ausführungsbeispiel der Abtaster-Steuereinrichtung,

Fig. 3    ein Schaltglied für die in den Fig. 1 und 2 angegebenen Laufzeitglieder,

Fig. 4    ein Impulsdiagramm für verschiedene in den Fig. 1 bis 3 auftretende Impulse,

Fig. 5    ein weiteres Schaltglied für die Laufzeitglieder gemäß den Fig. 1 und 2 und

Fig. 6    ein Impulsdiagramm für in dem Schaltglied gemäß Fig. 5 auftretende Impulse.

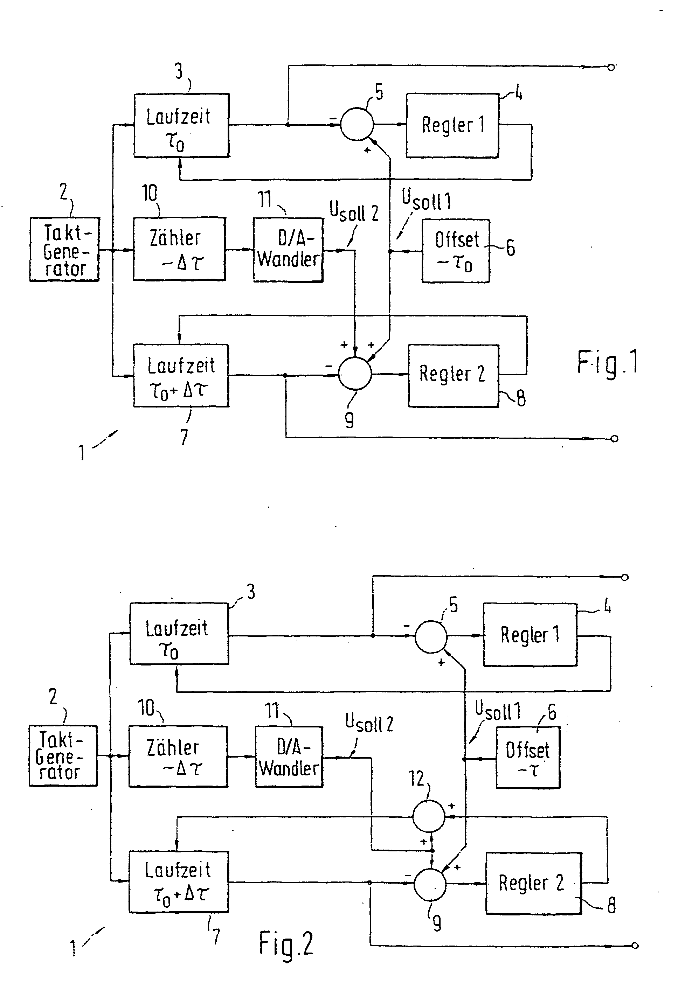

Fig. 1 zeigt schematisch ein erstes Ausführungsbeispiel für eine Abtaster-Steuereinrichtung 1 mit einem Taktgenerator 2, der Taktimpulse an ein Laufzeitglied 3 zur Erzeugung von Pulsen einer Laufzeit $\tau_0$ und an ein weiteres Laufzeitglied 7 zur Abgabe von weiteren Impulsen einer Laufzeit $\tau_0 + \Delta\tau$ sowie an einen Zähler 10 zur Erzeugung einer Verzögerungszeit $\Delta\tau$ abgibt.

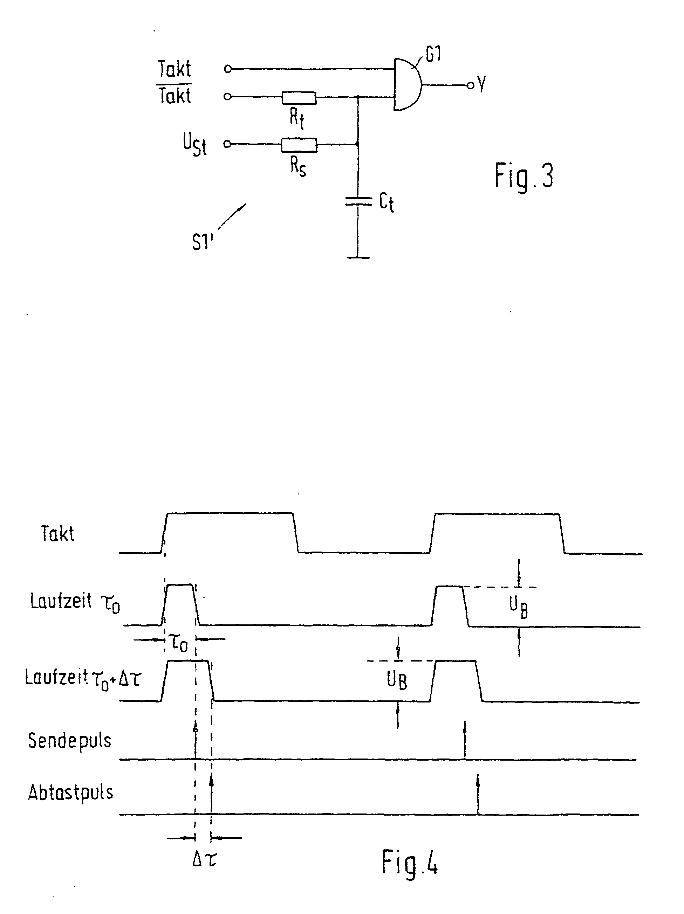

Die Impulse der Laufzeit $\tau_0$ werden über eine Summationsstelle 5 einem Regler 4 zugeführt, dessen Ausgang auf das Laufzeitglied 3 rückgekoppelt ist. Der Summationsstelle 5 wird außerdem von einem Steuerglied 6 als Sollwert eine Sollspannung $U_{soll1}$ zugeführt. Das Ausgangssignal des Laufzeitglieds 3 wird abgezweigt und zur Bildung der Sendeimpulse mit der abfallenden Flanke der Pulse der Laufzeit $\tau_0$ herangezogen, wie aus dem in Fig. 4 gezeigten Impuls-diagramm hervorgeht.

Entsprechend wird auch das Ausgangssignal des weiteren Laufzeitglieds 7 über eine weitere Summationsstelle 9 und einen weiteren Regler 8 geregelt, dessen Ausgang auf das weitere Laufzeitglied 7 rückgekoppelt ist. Der weiteren Summationsstelle 9 wird ebenfalls die Sollspannung $U_{soll1}$ zugeführt und zusätzlich eine weitere Sollspannung $U_{soll2}$, die durch eine Digital-Analog-Wandlung der von dem Zähler 10 ausgegebenen Zählpulse mittels eines D/A-Wandlers 11 erzeugt wird. Das Ausgangssignal des weiteren Lauftzeitglieds 7 wird abgezweigt, um mittels seiner abfallenden Impulsflanken die um die Verzögerung $\Delta_T$ zeitverzögerten Abtastimpulse zu erzeugen, wie aus Fig. 4 ebenfalls ersichtlich.

Fig. 2 zeigt eine abgewandelte Ausführungsform der in Fig. 1 gezeigten Abtaster-Steuereinrichtung 1. Hierbei wird die zusätzliche Sollspannung $U_{soll2}$ weiterhin einem in dem Rückkopplungszweig zwischen dem weiteren Regler 8 und dem weiteren Laufzeitglied 7 angeordneten Summationsglied 12 zugeführt.

Fig. 3 zeigt ein Schaltglied S1', das zur Erzeugung der geregelten Ausgangsimpulse in dem Laufzeitglied 3 und dem weiteren Laufzeitglied 7 verwendbar ist. Das Schaltglied S1' weist ein AND-Gatter G1 auf, dessen einem Eingang das Taktsignal Takt des Taktgenerators 2 zugeführt wird und an dessen anderem Eingang das invertierte Taktsignal des Taktgenerators 2 über einen Widerstand $R_t$ sowie eine überlagernde Steuer-Gleichspannung $U_{ST}$ über einen Steuer-Widerstand $R_S$ liegt und der über einen Kondensator $C_t$ an Masse liegt, wobei mittels der Widerstände $R_t$, $R_S$ und des Kondensators $C_t$ eine geeignete Laufzeit $T_0$ bzw. eine Laufzeit mit Verzögerung $\tau_0 + \Delta\tau$ einstellbar ist.

Wie aus Fig. 4 ersichtlich, werden, beginnend mit der steigenden Taktflanke des Taktsignals Takt, die beiden Rechtecksignale der Dauer $\tau_0$ bzw. $\tau_0 + \Delta\tau$ erzeugt, wobei $\tau_0$ eine feste, und $\Delta\tau$ eine von der Steuer-Gleichspannung $U_{ST}$ mehr oder weniger linear beeinflußbare variable Verzögerung ist. Die Amplitude der Signale ist $U_B$.

Bei dem Schaltglied S1' wird das Taktsignal entsprechend Fig. 4 auf den einen, das invertierte und über das Verzögerungsglied $R_tC_t$ verzögerte Taktsignal wird auf den anderen Eingang des AND-Gatters G1 gegeben. Es entsteht ein positiver Impuls, wie in Fig. 4, dritte Zeile gezeigt. Durch Überlagerung der Steuer-Gleichspannung $U_{ST}$ läßt sich die Laufzeit der Anordnung verändern, da das AND-Gatter G1 immer im gleichen Schaltpunkt schaltet, sich jedoch das verzögerte Taktsignal wegen der Steuer-Gleichspannung $U_{ST}$ entsprechend der Spannung verschiebt.

Anstatt des AND-Gatters G1 lassen sich prinzipiell NAND, OR oder NOR-Gatter einsetzen. Vorteilhafterweise stammen das Takt- und das inverse Taktsignal aus einem Flipflop mit komplementären Ausgängen, wodurch keine Verschiebung der beiden Signale zueinander auftritt.

Als Stellglied für die Laufzeit $\tau_0 + \Delta\tau$ bzw. die steuerbare Verzögerung $\Delta\tau$ kommen ebenfalls schnelle CMOS-, ECL- oder TTL-Gatter in Verbindung mit RC-, RL- oder LC-Gliedern in Frage. Die Steuerung der Laufzeit kann hierbei durch Veränderung der beteiligten Komponenten R, L, C erfolgen. Eine Spannungssteuerung einer Kapazität kann z.B. durch den Einsatz einer Kapazitätsdiode, eine Spannungssteuerung eines Widerstands durch Verwendung eines Feldeffekttransistors erfolgen.

Die erzielte Verzögerung $\Delta\tau$ als Funktion der Steuerspannung $U_{ST}$ ist bei allen genannten Verfahren in der Regel nichtlinear. Deshalb wird eine Regelung der Laufzeit mit den in Fig. 1 und Fig. 2 gezeigten Abtaster-Steuereinrichtungen 1 gemäß folgendem Verfahren durchgeführt:

Durch analoge Mittelwertbildung in einem Integrator oder Tiefpaß wird der mittlere Gleichanteil der Signale mit der Dauer $\tau_0$ bzw. $\tau_0 + \Delta\tau$ und der Amplitude $U_B$ gemessen und jeweils mit dem vorgegebenen Sollwert $U_{soll1}$ bzw. $U_{soll1} + U_{soll2}$ verglichen. Der Regler 4 und der weitere Regler 8 verändern die zugehörige Steuer-Gleichspannung so, daß der Mittelwert gleich dem entsprechenden Sollwert ist. Die Wiederholrate der Impulse sei $f_0$. Es gilt dann:

$$U_B \cdot \tau_0 \cdot f_0 = U_{soll1}$$

$$U_B \cdot (\tau_0 + \Delta\tau) \cdot f_0 = U_{soll1} + U_{soll2}.$$

Dadurch wird erreicht, daß die feste Laufzeit $\tau_0$ des am Ausgang des Laufzeitglieds 3 anstehenden ersten Signals proportional der fest vorgegebenen ersten Sollspannung $U_{soll1}$ wird. Die zusätzliche, variabel steuerbare Verzögerung $\Delta\tau$ des am Ausgang des weiteren Laufzeitglieds 7 anstehenden zweiten Signals wird proportional zu der weiteren Sollspannung $U_{soll2}$, unabhängig von Bauteiletoleranzen. Werden die Sollspannungen $U_{soll1}$ und $U_{soll2}$ jeweils proportional aus der Spannungsamplitude $U_B$ einer Gatterbetriebsspannung gebildet, fällt auch die Abhängigkeit der Gatterbetriebsspannung heraus.

Dementsprechend wird bei den Ausführungsbeispielen gemäß Fig. 1 und Fig. 2 bei den Reglern 4 bzw. 8 die Sollspannung $U_{soll1}$, die einer Laufzeit $\tau_0$ entspricht, als Sollwert vorgegeben. Der weitere Regler 8 erhält additiv die Sollspannung $U_{soll2}$ als Sollwert, die der Verzögerung $\Delta\tau$ entspricht. Die Steuerung der Zusatzlaufzeit erfolgt über den Zähler 10 mit dem nachgeschalteten D/A-Wandler 11. Die so erzielte Quantisierung der Verzögerung $\Delta\tau$ kann sehr fein gewählt werden, es sind Werte von unter 50 ps reproduzierbar möglich.

Bei einem in Fig. 2 gezeigten weiteren Ausführungsbeispiel wirkt die steuernde Sollspannung $U_{soll2}$ nicht nur auf den Regler, sondern mit einer entsprechenden Gewichtung versehen auch direkt auf den Steuereingang des weiteren Laufzeitglieds 7. Somit muß der weitere Regler 8 nur noch Fehler in der gewählten Gewichtung und Effekte von Nichtlinearitäten ausgleichen, wobei sich der nutzbare Frequenzbereich für das steuernde Sollsignal $U_{soll2}$ deutlich vergrößert.

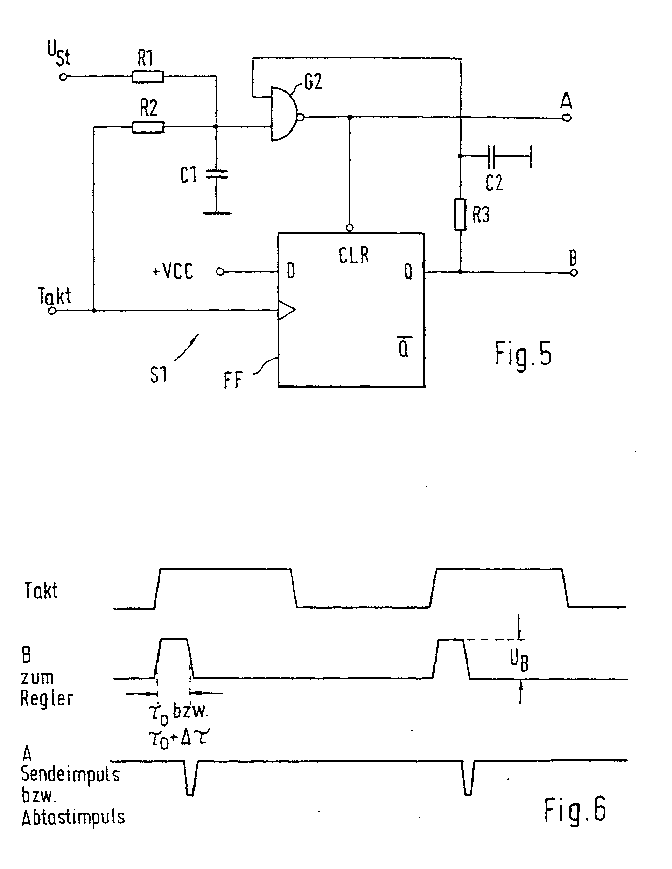

Anstelle des in Fig. 3 gezeigten Schaltglieds S1' kann in dem Laufzeitglied 3 bzw. dem weiteren Laufzeitglied 7 das Schaltglied S1 gemäß Fig. 5 vorgesehen sein, das zum Erzeugen der Sendeimpulse bzw. Abtastimpulse und zur Erzeugung der zum Regler geführten Impulse der Amplitude $U_B$ und der Dauer $\tau_0$ bzw. $\tau_0 + \Delta_T$ zum Zwecke der Regelung der Laufzeiten $\tau_0$ bzw. $\tau_0 + \Delta\tau$ dient.

Das Schaltglied S1 weist ein NAND-Gatter G2 auf, an dessen einem Eingang die Steuer-Gleichspannung $U_{ST}$ über einen Widerstand R1 sowie das Taktsignal Takt über einen Widerstand R2 liegt und der über einen Kondensator C1 auf Masse liegt. Ferner weist das Schaltglied S1 ein Flipflop FF auf, an dessen Takteingang das Taktsignal Takt liegt und dessen nichtinvertierender Ausgang Q über einen Widerstand R3 an den anderen Eingang des NAND-Gatters G2 angeschlossen ist, der über einen weiteren Kondensator C2 auf Masse liegt. Der Ausgang des NAND-Gatters G2 ist mit einem Rücksetzeingang des Flipflops FF verbunden.

Bei der steigenden Flanke der Taktsignale Takt wird der Ausgang Q des Flipflops FF auf logisch 1 gesetzt. Kurz darauf ist der weitere Kondensator C2 auf logisch 1 aufgeladen, d.h. auf eine Spannung, die das NAND-Gatter G2 als logisch 1 erkennt. Da die Zeitkonstante R3C2 kleiner ist als die mit den Widerständen R1 und R2 und dem Kondensator C1 gebildete Zeitkonstante, ist etwas später der Kondensator C1 auf logisch 1 aufgeladen. Der Zeitpunkt, zu dem die Spannung an dem Kondensator C1 den logischen Pegel 1 erreicht, ist durch die von außen zugeführte analoge Steuer-Gleichspannung $U_{ST}$ beeinflußbar.

Nachdem beide Eingänge des NAND-Gatters G2 auf logisch 1 liegen, wird das Signal an einem Ausgang A für das Sendesignal logisch 0. Dadurch wird ein Rücksetzen des Flipflops FF bewirkt (Q = 0) und anschließend der Ausgang A wieder auf logisch 1 gesetzt. Der Widerstand R3 und der Kondensator C2 bewirken dabei eine ausreichende Dauer des Rücksetzsignals am Ausgang des NAND-Gatters G2. Der Vorgang wiederholt sich mit der nächsten steigenden Taktflanke.

Die fallende Flanke des Signals an dem Ausgang A dient direkt zum Triggern eines die Sendesignale abgebenden Senders bzw. eines die Abtastsignale abgebenden Abtasters. Das Signal an dem nichtinvertierenden Ausgang Q des Flipflops FF bzw. dem Ausgang B wird der Regelung zugeführt, die die Impulsbreite der zum Regler 4 bzw. 8 geführten Impulse auf den gewünschten Wert $\tau_0$ bzw. $\tau_0 + \Delta\tau$ regelt. Fig. 6 zeigt ein Zeitdiagramm der Taktsignale Takt und der Signale an den Ausgängen A und B.

Die Vorteile dieses Schaltglieds S1 bzw. der damit aufgebauten Laufzeitglieder 3, 7 liegen darin, daß es zwei getrennte Ausgänge A (für die Sende- bzw. Abtatsimpulse) und B (Impulse für die Regelung) besitzt. Dadurch werden weitere Schaltungsabschnitte für die Erzeugung der eigentlichen Sende- bzw. Abtastimpulse erspart und eine hohe Genauigkeit erreicht. Das Signal an dem Ausgang B selbst ist für die Ansteuerung des Senders bzw. des Abtasters in der Regel (z. B. bei der Verwendung von Step-Recovery-Dioden) ungeeignet, da B eine variable Länge aufweist. Sender und Abtaster benötigen meist kurze Impulse konstanter Dauer.

Die Lage der fallenden Flanke des Signals an dem Ausgang A, die den Send- bzw. Abtastzeitpunkt bestimmt, wird bei der Ausführung nach Fig. 5 mit-geregelt, wodurch sich ein wesentlicher Vorteil ergibt.

**Patentansprüche**

1. Abtaster-Steuereinrichtung (1) für die Abtastung eines durch zurückkommende Sendeimpulse gebildeten Echosignals mit einem Taktgenerator (2), der Impulse an Laufzeitglieder (3, 7) abgibt , wobei das Ausgangssignal des Laufzeitglieds (3) zur Bildung von Sendeimpulsen und das Ausgangssignal der weiteren LaufZeitglieds (7) zur Bildung von Abtastimpulsen dient, und mit einem Einstellglied (10) zum Ändern einer Verzögerungszeit $\Delta\tau$ der Abtastimpulse,
   **dadurch gekennzeichnet,**
   **daß** das Laufzeitglied (3) für die Sendeimpulse Glied einer ersten Regelschleife mit einer Summationsstelle (5) und einem Regler (4) und das weitere Laufzeitglied (7) Glied einer zweiten Regelschleife mit einer weiteren Summationsstelle (9) und einem weiteren Regler (8) ist und
   **daß** der Summationsstelle (5) und der weiteren Summationsstelle (9) ein gleicher Sollwert ($U_{soll1}$) und der weiteren Summationsstelle (9) zusätzlich ein weiterer Sollwert ($U_{soll2}$), der zum Ändern der Verzögerungszeit ($\Delta\tau$) variiert wird, zugeführt werden.

2. Steuereinrichtung nach Anspruch 1,
   **dadurch gekennzeichnet,**
   **daß** das Laufzeitglied (3) und das weitere Laufzeitglied (7) jeweils mindestens ein Schaltglied (S1, S1') aufweisen, das bei einer bestimmten Schwellenspannung umschaltet, und
   **daß** mittels des Reglers (4) und des weiteren Reglers (8) eine an das Schaltglied (S1, S1') angelegte Steuer-Gleichspannung ($U_{ST}$) geregelt wird.

3. Steuereinrichtung nach Anspruch 1 oder 2,
   **dadurch gekennzeichnet,**
   **daß** der der Summationsstelle (5) und der weiteren Summationsstelle (9) zugeführte Sollwert ($U_{soll1}$) sowie der weitere Sollwert ($U_{soll2}$) Gleichspannungen sind.

4. Steuereinrichtung nach einem der vorhergehenden Ansprüche,
   **dadurch gekennzeichnet,**
   **daß** der weitere Sollwert ($U_{soll2}$) eine mittels eines Zählers (10) und eines diesem nachgeschalteten D/A-Wandlers (11) gebildete Gleichspannung ist und
   **daß** der Zähler (10) mittels des Taktgenerators (2) getaktet ist.

5. Steuereinrichtung nach einem der vorhergehenden Ansprüche,
   **dadurch gekennzeichnet,**
   **daß** in der zweiten Regelschleife zwischen dem weiteren Regler (8) und dem weiteren Laufzeitglied (7) ein Summationsglied (12) vorgesehen ist, dem der weitere Sollwert ($U_{soll2}$) zugeführt wird.

6. Steuereinrichtung nach einem der Ansprüche 2 bis 5,
   **dadurch gekennzeichnet,**
   **daß** das Schaltglied (S1) ein AND-Gatter (G1) aufweist, dessen einem Eingang das Taktsignal des Taktgenerators (2) zugeführt ist und dessen anderer Eingang mit einem RC-, ($R_tC_t$), RL- oder LC-Glied beschaltet und mit einem Eingangssignal mit der überlagerten Steuer-Gleichspannung ($U_{ST}$) beaufschlagt ist.

7. Steuereinrichtung nach Anspruch 6,
   **dadurch gekennzeichnet,**
   **daß** dem anderen Eingang als Eingangssignal das invertierte Taktsignal mit der überlagerten Steuer-Gleichspannung ($U_{ST}$) zugeführt wird.

8. Steuereinrichtung nach einem der Ansprüche 2 bis 5,
   **dadurch gekennzeichnet,**
   **daß** das Schaltglied (S1) ein NAND-Gatter (G2) und ein Flipflop (FF) aufweist, dessen Takt-Eingang das Taktsignal des Taktgenerators (2) zugeführt wird und dessen einer Ausgang (Q) über ein Zeitglied (R3C2) mit einem Eingang des NAND-Gatters (G2) verbunden ist und zum Regler (4 bzw. weiterer Regler 8) führt,
   **daß** der andere Eingang des NAND-Gitters über ein weiteres Zeitglied (R1,R2,C1) einerseits mit dem Taktsignal und andererseits mit der diesem überlagerten Steuer-Gleichspannung ($U_{ST}$) beaufschlagt wird und

**daß** der Ausgang des NAND-Gatters (G2) mit einem Rücksetzeinga ng (CLR) des Flipflops (FF) verbunden ist und abfallende Flanken des Ausgangssignals des NAND-Gatters (G2) direkt zum Triggern der Sendeim-pulse bzw. der Abtastimpulse dienen.

## Claims

1.  Sampler control device (1) for sampling an echo signal formed by returning transmitted pulses, having a clock generator (2) which outputs pulses to delay elements (3, 7), the output signal of the delay element (3) serving to form transmitted pulses, and the output signal of the other delay element (7) serving to form strobe pulses, and having a setting element (10) for changing a delay time $\Delta\tau$ of the strobe pulses, **characterized in that** the delay element (3) for the transmitted pulses is an element of a first closed loop with a summing point (5) and a controller (4), and the further delay element (7) is an element of a second closed loop with a further summing point (10) and a further controller (8), and **in that** the summing point (5) and the further summing point (9) are fed an identical desired value ($U_{soll1}$), and the further summing point (9) is additionally fed a further desired value ($U_{soll2}$) which is varied in order to change the delay time ($\Delta\tau$).

2.  Control device according to Claim 1, **characterized in that** the delay element (3) and the further delay element (7) in each case have at least one switching element (S1, S1') which switches over at a specific threshold voltage, and **in that** the controller (4) and the further controller (8) are used to control a control DC voltage ($U_{ST}$) applied to the switching element (S1, S1').

3.  Control device according to Claim 1 or 2, **characterized in that** the desired value ($U_{soll1}$) and the further desired value ($U_{soll2}$) fed to the summing point (5) and the further summing point (9) are DC voltages.

4.  Control device according to one of the preceding claims, **characterized in that** the further desired value ($U_{soll2}$) is a DC voltage formed by means of a counter (10) and a D/A converter (11) connected downstream thereof, and **in that** the counter (10) is clocked with the aid of the clock generator (2).

5.  Control device according to one of the preceding claims, **characterized in that** provided in the second closed loop between the further controller (8) and the further monoflop (7) is a summing element (12) which is fed the further desired value ($U_{soll2}$).

6.  Control device according to one of Claims 2 to 5, **characterized in that** the switching element (S1) has an AND gate (G1), whose one input is fed the clock signal of the clock generator (2), and whose other input is connected to an RC, ($R_tC_t$), RL or LC element and has applied to it an input signal with the superimposed control DC voltage ($U_{ST}$).

7.  Control device according to Claim 6, **characterized in that** the inverted clock signal with the superimposed control DC voltage ($U_{ST}$) is fed to the other input as input signal.

8.  Control device according to one of Claims 2 to 5, **characterized in that** the switching element (S1) has a NAND gate (G2) and a flipflop (FF) whose clock input is fed the clock signal of the clock generator (2), and of which one output (Q) is connected via a timing element (R3C2) to an input of the NAND gate (G2) and leads to the controller (4 or further controller 8), **in that** the other input of the NAND gate has applied to it via a further timing element (R1, R2, C1) the clock signal, on the one hand, and the control DC voltage ($U_{ST}$) super-imposed on the latter, on the other hand, and **in that** the output of the NAND gate (G2) is connected to a reset input (CLR) of the flipflop (FF), and falling edges of the output signal of the NAND gate (G2) serve directly to trigger the transmitted pulses or the strobe pulses.

## Revendications

1.  Installation de commande d'échantillonnage (1) pour échantillonner un signal d'écho formé par les impulsions d'émission de retour comprenant un générateur d'horloge (2) fournissant des impulsions à des éléments de temps de parcours (3, 7), le signal de sortie de l'élément de temps de parcours (3) servant à former des impulsions d'émission et le signal de sortie de l'autre élément de temps parcours (7) servant à former des impulsions d'échantillonnage, ainsi qu'un organe de réglage (10) pour modifier une durée de temporisation ($\Delta\tau$) des impulsions d'échantillonnage,
    **caractérisée en ce que**
    l'élément de temps de parcours (3) pour les impulsions d'émission fait partie d'une première boucle de régulation avec un point de sommation (5) et un régulateur (4) et l'autre élément de temps de parcours (7) fait partie d'une seconde boucle de régulation ayant un autre point de sommation (9) et un autre régulateur (8), et
    le point de sommation (5) et l'autre point de sommation (9) reçoivent une même valeur de consigne ($U_{cons1}$) et l'autre point de sommation (9) reçoit en plus une autre valeur de consigne ($U_{cons2}$) que l'on modifie pour changer la durée de temporisation ($\Delta\tau$).

2. Installation de commande selon la revendication 1,
   **caractérisée en ce que**
   l'élément de temps de parcours (3) et l'autre élément de temps de parcours (7) ont chacun au moins un élément de commutation (S1, S1') qui commute pour une certaine tension de seuil, et
   le régulateur (4) et l'autre régulateur (8) règlent la tension continue de commande ($U_{ST}$) appliquée à l'élément de commutation (S1, S1').

3. Installation de commande selon l'une quelconque des revendications 1 ou 2,
   **caractérisée en ce que**
   la valeur de consigne ($U_{cons1}$) ainsi que l'autre valeur de consigne ($U_{cons2}$) appliquée au point de sommation (5) et à l'autre point de sommation (9) sont des tensions continues.

4. Installation de commande selon l'une quelconque des revendications précédentes,
   **caractérisée en ce que**
   l'autre valeur de consigne ($U_{cons2}$) est une tension continue formée à l'aide d'un compteur (10) et d'un convertisseur numérique/analogique (11) en aval de celui-ci, et
   le compteur (10) est commandé en cadence à l'aide du générateur d'horloge (2).

5. Installation de commande selon l'une quelconque des revendications précédentes,
   **caractérisée en ce que**
   la seconde boucle de régulation comporte entre l'autre régulateur (8) et l'autre élément de temps de parcours (7) un élément de sommation (12) recevant l'autre valeur de consigne ($U_{cons2}$).

6. Installation de commande selon l'une quelconque des revendications 2 à 5,
   **caractérisée en ce que**
   l'élément de commutation (S1) comporte une porte ET (G1) dont une entrée reçoit le signal d'horloge du générateur d'horloge (2) et dont l'autre entrée est reliée à un élément RC ($R_tC_t$), RL ou LC et une entrée reçoit la tension continue de commande combinée ($U_{ST}$).

7. Installation de commande selon la revendication 6,
   **caractérisée en ce que**
   l'autre entrée reçoit comme signal d'entrée, le signal d'horloge inversé combiné à la tension continue de commande ($U_{ST}$).

8. Installation de commande selon l'une quelconque des revendications 2 à 5,
   **caractérisée en ce que**
   l'élément de commutation (S1) comporte une porte NON-ET (G2) et un Flip Flop (FF) dont l'entrée d'horloge reçoit le signal d'horloge du générateur d'horloge (2) et dont la sortie (Q) est reliée par un élément de temporisation (R3C2) à une entrée de la porte NON-ET (G2) et conduit au régulateur (4) ou à l'autre régulateur (8),
   l'autre entrée de la porte NON-ET reçoit par l'intermédiaire d'un autre élément de temporisation (R1,R2,C1) d'une part le signal d'horloge et d'autre part la tension continue de commande ($U_{ST}$) combinée à ce signal, et
   la sortie de la porte NON-ET (G2) est reliée à l'entrée de remise à l'état initial (CLR) du Flip Flop (FF) et les flancs descendant du signal de sortie de la porte NON-ET (G2) servent directement à déclencher les impulsions d'émission ou les impulsions d'échantillonnage.

Fig.1

Fig.2

Takt
$\overline{\text{Takt}}$

$R_t$

$U_{St}$

$R_s$

$C_t$

G1

Y

S1'

Fig.3

Takt

Laufzeit $\tau_0$

$U_B$

$\tau_0$

Laufzeit $\tau_0 + \Delta\tau$

$U_B$

Sendepuls

Abtastpuls

$\Delta\tau$

Fig.4

Fig.5

Fig.6